# EUROPEAN PATENT APPLICATION

(11) **EP 4 443 233 A1**
(43) Date of publication of application: **09.10.2024**
(21) Application number: 23191600.8
(22) Date of filing: 16.08.2023
(51) Int. Cl.: G03F 1/24, G03F 1/26, G03F 1/80

(54) **PHASE SHIFT BLANKMASK AND PHOTOMASK FOR EUV LITHOGRAPHY**

(30) Priority: 03.04.2023 KR 20230043333; 27.07.2023 KR 20230097936
(71) Applicant: S&S Tech Co., Ltd., Daegu 42714 (KR)
(72) Inventor: PARK, Min-Kwang, 42714 Daegu (KR); PARK, Min-Kyu, 42714 Daegu (KR); WOO, Mi-Kyung, 42714 Daegu (KR); YANG, Chul-Kyu, 42714 Daegu (KR); KIM, Yong-Dae, 42714 Daegu (KR)
(74) Representative: ABG Intellectual Property Law, S.L.

(57) **Abstract**

Disclosed is a blankmask for EUV lithography. The blankmask has a reflective flim formed on a substrate, a capping film containing ruthenium (Ru), an etch stop film containing tantalum (Ta) and antimony (Sb), and a phase shift film containing ruthenium (Ru). The etch stop film has a composition ratio of tantalum (Ta) and antimony (Sb) ranging from 3:7 to 7:3. The stacked structure of the phase shift film containing ruthenium (Ru) and the etch stop film containing tantalum (Ta) and antimony (Sb) results in achieving a high extinction coefficient (k) and a low refractive index (n).

## Description

### CROSS-REFERENCE TO RELATED THE APPLICATION

This application is based on and claims priority to Korean Patent Applications No. 10-2023-0043333 filed on April 03, 2023 and No. 10-2023-0097936 filed on July 27, 2023 in the Korean Intellectual Property Office, the disclosure of which is incorporated by reference herein in its entirety.

### BACKGROUND

### Field

The present invention relates to a blankmask and photomask, and more particularly, to an Extreme Ultraviolet (EUV) lithography phase shift blankmask equipped with a phase shift film to shift the phase of EUV exposure light for achieving superior resolution during wafer printing and a photomask fabricated with the same.

### Description of the Related Art

Blankmasks used in Extreme Ultraviolet (EUV) lithography generally has two thin films on a substrate: a reflective film that reflects EUV light and an absorbing film that absorbs EUV light. Recently, there have been efforts to develop phase shift blankmasks that can achieve higher resolution compared to binary blankmasks with the absorbing film. Phase shift blankmasks have higher NILS (Normalized Image Log Slope) compared to binary blankmasks, allowing for a reduction in Stochastic Defects caused by Shot Noise Effect during wafer printing. Additionally, phase shift blankmasks enable low DtC (Dose to Clear) implementation, which can improve semiconductor productivity.

In EUV lithography, it is preferable to fabricate the phase shift blankmask with a phase shift film made from a material that is easy to fabricate photomask and offers excellent performance during wafer printing. Considering these factors, ruthenium (Ru) is being researched as a material for the phase shift film in EUV lithography phase shift blankmasks.

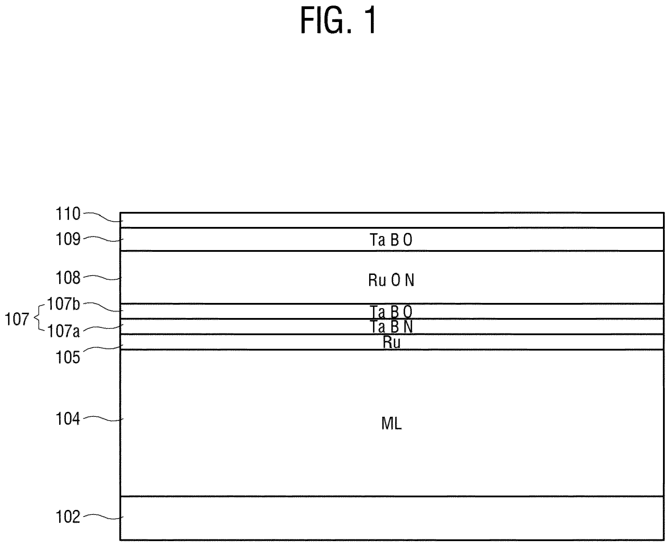

Figure 1 is a diagram illustrating the structure of an Extreme Ultraviolet (EUV) lithography phase shift blankmask that includes a phase shift film containing ruthenium (Ru). Figure 1 shows a construction devised by the inventors of the present invention in order to illustrate the technical feature of the invention in comparison with the prior construction, and the construction shown in Figure 1 has not been published before filing the present invention.

The EUV lithography phase shift blankmask includes a substrate 102, a reflective film 104 formed on the substrate 102, a capping film 105 formed on the reflective film 104, an etch stop film 107 formed on the capping film 105, a phase shift film 108 formed on the etch stop film 107, a hard mask film 109 formed on the phase shift film 108, and a resist film 110 formed on the hard mask film 109.

The capping film 105 is made of a material containing ruthenium (Ru), and the phase shift film 108 is also made of a material containing ruthenium (Ru), specifically RuON. The etch stop film 107 has a two-layer structure consisting of a first layer 107a on the capping film 105 and a second layer 107b on the first layer 107a. The first layer 107a is made of TaBN, and the second layer 107b is made of TaBO.

The hard mask film 109 is made of TaBO.

To fabricate a photomask using the above configuration of the blankmask, first, the pattern of the resist film 110 is formed through the developement process after e-beam writing, and the patterned resist film is then used as an etch mask to etch the hard mask film 109 made of TaBO. Fluorine-based gas is used as the etching gas for this process. After removing the resist film pattern, the patterned hard mask film is used as an etch mask to etch the phase shift film 108 using a chlorine (Cl₂)-based gas containing oxygen (O₂).

Meanwhile, tantalum (Ta) is etched by chlorine-based gas, but when oxygen (O) is added to tantalum (Ta), it is etched by fluorine-based gas. Therefore, in the etching process of the etch stop film 107, the second layer 107b of TaBO is first etched by fluorine-based gas, which also removes the pattern of the hard mask film 109. Then, a chlorine-based gas without oxygen (O₂) is used to etch the first layer 107a of the etch stop film 107. This completes the fabrication of the phase shift photomask.

In the structure of the phase shift blankmask as described above, the phase shift film 108 containing ruthenium (Ru) is etched using chlorine (Cl₂)-based gas. However, if only chlorine (Cl₂) gas is used for etching, the etching rate is very slow. To ensure a certain etching rate, a chlorine (Cl₂)-based gas containing oxygen (O₂) is used. However, in the structure shown in Figure 1, both the capping film 105 and the phase shift film 108 contain ruthenium (Ru). Therefore, if there is no etch stop film 107, the capping film 105 may be damaged by oxygen (O₂) in the etching gas during the etching process, leading to a decrease in the capping film's 105 reflectivity. The etch stop film 107 functions to prevent contact of the oxygen(O₂)-containing chlorine (Cl₂) gas to the capping film 105, thereby protecting the capping film 105 from damage.

When forming a phase shift film 107 containing Ru, it is preferable for the etch stop film 107 to be composed of a two-layer structure as described above. If the etch stop film 107 is a single film of TaBN, it is susceptible to oxidation on the surface of the etch stop film 107 due to the presence of oxygen (O₂) during the etching of the RuON phase shift film 108. This oxidation occurs randomly on the surface of the etch stop film 107, leading to defects on the surface of the etch stop film 107 and a decrease in the etching rate when using chlorine (Cl₂)-based gas. Additionally, etching with chlorine (Cl₂)-based gas is a chemical etching, while etching with fluorine (F)-based gas is a physical etching. Therefore, if the etch stop film 107 is a single film of TaBO, the capping film 105 would suffer physical damage during the etching with fluorine (F)-based gas.

Considering these issues, it is preferable to form the first layer 107a with TaBN and the second layer 107b with TaBO, whereby the capping film 105 is protected from damage caused by oxygen (O₂) and damage caused by fluorine (F)-based gas.

When applying the photomask fabricated with such a blankmask to wafer lithography, reducing the Dose to Clear (DtC) is required to improve productivity and increasing the Normalized Image Log Slope (NILS) is required to improve pattern critical dimension (CD). For reducing DtC, it is desirable for the phase shift film 108 to have a high extinction coefficient (k). Specifically, to prevent sidelobe phenomena during the lithography process, the relative reflectivity of the phase shift film 108 should be 15% or less, and to achieve a thinner phase shift film 108 while maintaining this low relative reflectivity, a high extinction coefficient (k) is required. To increase NILS, it is required for the phase shift film 108 to have a low refractive index (n). However, ruthenium (Ru) cannot simultaneously satisfy both of these requirements because it has a low refractive index (n) and a low extinction coefficient (k).

The etch stop film 107 below the phase shift film 108 also serves a phase shift function along with the phase shift film 108. Therefore, if the etch stop film 107 has a high extinction coefficient (k), the overall extinction coefficient (k) of the entire stack, i.e., the combined structure of the etch stop film 107 and the phase shift film 108 functioning as the phase shift film, becomes high. However, as the etch stop film 107 shown in Figure 1 contains tantalum (Ta) of relatively low extinction coefficient (k), about 0.04, for EUV wavelengths, the overall stack 107 and 108 functioning as the phase shift film cannot have a high extinction coefficient (k). Increasing the thickness of the etch stop film 107 can resolve this issue, but it would result in an increase in the overall thickness of the stack 107 and 108 functioning as the phase shift film, leading to worsened DtC and increased 3D effect.

### SUMMARY

The purpose of the present invention is to provide a solution that achieves a thin thickness, low relative reflectivity, low Dose to Clear (DtC), and high Normalized Image Log Slope (NILS) of the blankmask having a phase shift film containing ruthenium (Ru), by increasing the extinction coefficient (k) and reducing the refractive index (n) in the entire stack of the etch stop film and the phase shift film.

According to the present invention, an Extreme Ultraviolet (EUV) lithography phase shift blankmask includes a substrate, a reflective film formed on the substrate, a capping film formed on the reflective film and containing ruthenium (Ru), an etch stop film formed on the capping film and containing tantalum (Ta) and antimony (Sb), and a phase shift film formed on the etch stop film and containing ruthenium (Ru).

The etch stop film has a composition ratio of tantalum (Ta) to antimony (Sb) of 3:7 to 7:3. The etch stop film can have a higher amount of antimony (Sb) than tantalum (Ta).

The etch stop film may include nitrogen (N). It contains nitrogen (N) of 1 to 10at%.

The etch stop film may have a two-layer structure: a first layer formed on the capping film and containing nitrogen (N), and a second layer formed on the first layer and containing oxygen (O). The first layer includes nitrogen (N) of 1 to 10at%, and the second layer includes oxygen (O) of 1 to 10at%.

The etch stop film has a thickness of 2 to 20nm.

The phase shift film may further include nitrogen (N). It contains ruthenium (Ru) of 70 to 99at% and nitrogen (N) of 1 to 30at%.

The phase shift film may further include oxygen (O). It contains ruthenium (Ru) of 70 to 99at% and oxygen (O) of 1 to 30at%.

The phase shift film may further include nitrogen (N) and oxygen (O). It contains ruthenium (Ru) of 40 to 98at%, nitrogen (N) of 1 to 30at%, and oxygen (O) of 1 to 30at%. The phase shift film has a thickness of 25 to 40nm.

A hard mask film may be formed on the phase shift film.

The hard mask film may include tantalum (Ta) and oxygen (O).

The hard mask film may have a two-layer structure: a lower layer formed on the phase shift film and containing tantalum (Ta) and nitrogen (N), and an upper layer formed on the lower layer and containing tantalum (Ta) and oxygen (O). The lower layer includes tantalum (Ta) of 70 to 99at% and nitrogen (N) of 1 to 30at%, and the upper layer includes tantalum (Ta) of 70 to 99at% and oxygen (O) of 1 to 30at%.

The hard mask film may include boron (B).

The hard mask film may include chromium (Cr) and niobium (Nb). It contains chromium (Cr) to niobium (Nb) in a composition ratio of 3:7 to 6:4.

The hard mask film may further include one or more of carbon (C), oxygen (O), and nitrogen (N).

The hard mask film has a thickness of 2 to 4nm.

Another aspect of the present invention provides an EUV lithography photomask fabricated using the blankmask of the above configuration.

According to this invention, a stacked structure of a phase shift film containing ruthenium (Ru) and an etch stop film containing tantalum (Ta) and antimony (Sb) ensures a high extinction coefficient (k) and low refractive index (n). As a result, the required characteristics for the phase shift blankmask for extreme ultraviolet lithography are achieved, which include excellent resolution and NILS (Normalized Image Log Slope), and low DtC (Dose to Clear) during wafer printing.

### BRIEF DESCRIPTION OF THE DRAWINGS

Figure 1 shows a diagram illustrating the structure of the Extreme Ultraviolet (EUV) lithography phase shift blankmask.
Figure 2 illustrates a diagram of the EUV lithography phase shift blankmask according to the first embodiment of the present invention.
Figure 3 illustrates a diagram of the EUV lithography phase shift blankmask according to the second embodiment of the present invention.
Figure 4 illustrates a diagram of the EUV lithography phase shift blankmask according to the third embodiment of the present invention.
Figure 5 illustrates a diagram of the EUV lithography phase shift blankmask according to the fourth embodiment of the present invention.

### DETAILED DESCRIPTION OF EXEMPLARY EMBODIMENTS

The following will describe the invention in detail, referring to the attached drawings.

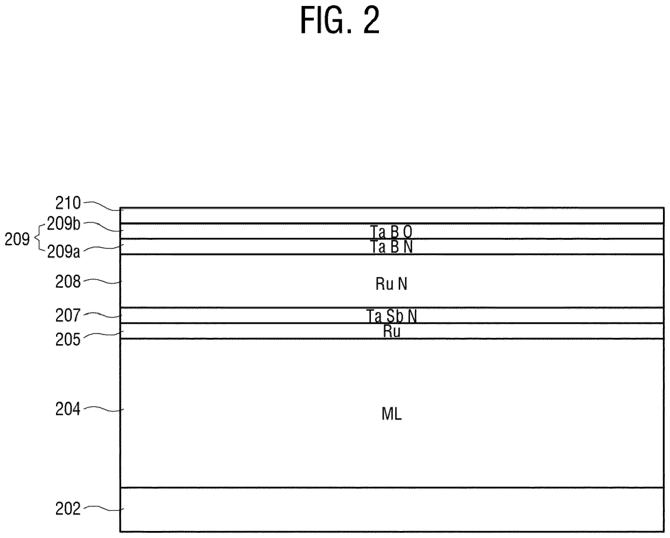

Figure 2 illustrates a diagram of the EUV lithography phase shift blankmask according to the first embodiment of the present invention.

The EUV lithography phase shift blankmask comprises a substrate 202, a reflective film 204 formed on the substrate 202, a capping film 205 formed on the reflective film 204, an etch stop film 207 formed on the capping film 205, a phase shift film 208 formed on the etch stop film 207, and a resist film 210 formed on the phase shift film 208.

The substrate 202 is a glass substrate suitable for reflective-type blankmasks using EUV light. It is designed to have a low coefficient of thermal expansion coefficient of 0±1.0×10⁻⁷/°C, preferably within 0±0.3×10⁻⁷/°C, using a Low Thermal Expansion Material (LTEM) glass substrate like SiO₂-TiO₂-based glass to prevent pattern deformation and stress caused by heat during exposure.

The reflective film 204 reflects EUV light and has a multi-layered structure with the refractive indices different from each other. Specifically, it consists of alternating accumulation structure of molybdenum (Mo) layer and silicon (Si) layer for 40 to 60 times. The capping film 205 prevents the formation of an oxide layer on the reflective film 204 to maintain its reflectivity for EUV light, and protects the reflective film 204 during the patterning of the etch stop film 207. It is typically made of a material containing ruthenium (Ru) and has a thickness of 2 to 5nm. The capping film 205 with a thickness of less than 2nm may not effectively perform its function, while a thickness of more than 5nm may reduce the reflectivity for EUV light.

The etch stop film 207 protects the capping film 205 during the etching of the phase shift film 208. The stop film 207 is etched using the pattern of the hard mask film 209 and the pattern of the phase shift film 208 after the patterning of the hard mask film 209 and the phase shift film 208 are completed. The etch stop film 207 has to be etched using a gas without oxygen (O₂) to prevent damage to the capping film 205.

The etch stop film 207 also provides the phase shift function for EUV light together with the phase shift film 208. Therefore, in the aspect of function, the entire stacked structure of the etch stop film 207 and the phase shift film 208 acts as a phase shift film. Hereinafter, the entire stacked structure of the etch stop film 207 and the phase shift film 208 will be referred to as the "entire phase shift film 207 and 208."

As the etch stop film 207 functions as a part of the entire phase shift film 207 and 208, to increase the extinction coefficient (k) of the entire phase shift film 207 and 208, it is preferable that the etch stop film 207 is made of a material with high extinction coefficient (k). Tantalum (Ta) and antimony (Sb) have higher extinction coefficients (k) for EUV light compared to ruthenium (Ru), the main constituent material of the phase shift film 208. Therefore, the extinction coefficient (k) of the entire phase shift film 207 and 208 can be higher by the etch stop film 207 including tantalum (Ta) and antimony (Sb). The content ratio of tantalum (Ta) to antimony (Sb) can range from 3:7 to 7:3.

The etch stop film 207 is designed to have the extinction coefficient (k) of 0.05 or higher, preferably 0.06 or higher. As antimony (Sb) has a higher extinction coefficient (k) compared to tantalum (Ta), it is preferable that the content of antimony (Sb) is higher than the content of tantalum (Ta) to secure such extinction coefficient (k).

The etch stop film (207) can further contain nitrogen (N). When nitrogen (N) is added, the extinction coefficient (k) and refractive index (n) of the etch stop film 207 can be controlled by adjusting the content of nitrogen (N). It is preferable that the nitrogen (N) content is 1 to 10at%. The etch stop film 207 composed of TaSbN is etched by a chlorine (Cl₂)-based etching gas that does not include oxygen (O₂).

The etch stop film 207 has a thickness of 2 to 20nm.

The phase shift film 208 shifts the phase of the exposure light, thereby cancelling the exposure light reflected by the reflective film 204. The phase shift film 208 includes ruthenium (Ru). The phase shift film 208 is etched by a chlorine (Cl₂)-based gas, and especially, it is etched by a chlorine (Cl₂)-based gas that includes oxygen (O₂) in order to secure the etching rate.

The phase shift film 208 can further contain nitrogen (N). When nitrogen (N) is included, it facilitates the control of the refractive index (n) of the phase shift film 208, making it easier to achieve the desired phase shift amount. This leads to an improved NILS (Normalized Image Log-Slope) and allows the thickness of the phase shift film 208 to be reduced. If nitrogen (N) is included, the nitrogen (N) content should be appropriately selected. For the phase shift film 208 composed of RuN, the nitrogen (N) content is preferably 30at% or less. Specifically, the phase shift film 208 includes Ru of 70-99at% and N of 1-30at%.

The phase shift film 208 can further include oxygen (O). When oxygen (O) is included, the reflectance of the phase shift film 208 for DUV wavelength is lowered, making the inspection of the phase shift film 208 with DUV inspection light more effective. For the phase shift film 208 composed of RuO, the oxygen (O) content is preferably 30at% or less. Specifically, the phase shift film 208 includes Ru of 70-99at% and O of 1-30at%. The phase shift film 208 can further contain both nitrogen (N) and oxygen (O). When both of nitrogen (N) and oxygen (O) are included, by adjusting the ratio of their content, the respective effects of containing nitrogen (N) and oxygen (O) can be obtained simultaneously. For the phase shift film 208 composed of RuON, the contents of nitrogen (N) and oxygen (O) is preferably 30at% or less, respectively. Specifically, the phase shift film 208 includes Ru of 40-98at%, N of 1-30at%, and O of 1-30at%.

The phase shift film 208 has a thickness of 25 to 40nm.

At a wavelength of 13.5nm, the relative reflectance of the entire phase shift film 207 is 6 to 15%. Here, the relative reflectance means the ratio of the reflectance of the entire phase shift film 207 and 208 to the reflectance of the stacked structure of the reflective film 204 and the capping film 205. The entire phase shift film 207 and 208 has a phase shift amount of 180-220°, preferably 185-220°.

The hard mask film 209 is used as an etching mask during the etching process of the phase shift film 208, and for this purpose, the hard mask film 209 is formed of a material having an etching selectivity with respect to the phase shift film 208.

If the hard mask film 209 is composed as a single layer, it may include tantalum (Ta) and oxygen (O). The hard mask film 209 including tantalum (Ta) is etched by a fluorine (F)-based etching gas when it further includes oxygen (O), and is etched by a chlorine (Cl₂)-based etching gas when it does not include oxygen (O). Therefore, the single-layered hard mask film 209 that includes tantalum (Ta) and oxygen (O) is etched by a fluorine (F)-based etching gas.

The hard mask film 209 can also have a two-layered structure as shown in FIG. 2. Specifically, the hard mask film 209 includes a lower layer 209a formed on the phase shift film 208 and an upper layer 209b formed on the lower layer 209a. The lower layer 209a further contains nitrogen (N), and the upper layer (209b) further contains oxygen (O). Therefore, the lower layer 209a is etched by a chlorine (Cl₂)-based etching gas, and the upper layer 209b is etched by a fluorine (F)-based etching gas. The lower layer 209a includes tantalum (Ta) of 70-99at% and nitrogen (N) of 1-30at%, and the upper layer 209b includes tantalum (Ta) of 70-99at% and oxygen (O) of 1-30at%.

If the hard mask film 209 is composed of a single layer containing tantalum (Ta) and oxygen (O) and therefore it is etched by the fluorine (F)-based etching gas, the fluorine (F) gas would cause damage to the phase shift film 208 during the etching process. However, by forming the hard mask film 209 in a two-layered structure, the upper layer (209b) is etched by the fluorine (F)-based gas and the lower layer 209a is etched by the chlorine (Cl₂)-based gas without oxygen (O₂), and therefore such damage is prevented. The hard mask film 209 can further contain boron (B). The boron (B) content in the hard mask film 209 is 20at% or less, preferably 15at% or less. In this case, the lower layer 207a is composed of TaBN, and the upper layer 207b is composed of TaBO.

The hard mask film 209 has a thickness of 5nm or less, preferably 2 to 4nm. If the hard mask film 209 has a two-layer structure, it is preferable for the upper layer 209b and the lower layer 209a to each have a thickness of 3nm or less.

The resist film 210 is composed of a Chemically Amplified Resist (CAR). The resist film 210 has a thickness of 40 to 100nm, preferably 40 to 80nm.

In the blankmask of the present invention, as the etch stop film 207 has a high extinction coefficient (k), the extinction coefficient (k) of the entire phase shift film 207 and 208 increases. Moreover, as the refractive index (n) of the entire phase shift film 207 and 208 is low, the desired phase shift amount is obtained even with a thin thickness of 40nm or less. As a result, the DtC is lowered to increase the productivity and the NILS is improved to enhance pattern accuracy.

The process of fabricating a photomask using the blankmask with the above configuration is as follows:
First, the pattern of the resist film 210 is formed through e-beam writing and development processes. Then, using the resist film pattern as a etching mask, the hard mask film 209 is etched. For the etching of the TaBO single-layer structure of the hard mask film 209, a fluorine (F)-based etching gas is used. In the case of the TaBO/TaBN two-layer structure of the hard mask film 209, the upper layer 209b is etched using the fluorine (F)-based etching gas, and then the lower layer 209a is etched using a chlorine (Cl₂)-based etching gas without oxygen (O₂).

After removing the resist film pattern, the pattern of the hard mask film 209 is used as an etching mask to etch the phase shift film 208. The etching of the phase shift film 208 is performed using a chlorine (Cl₂)-based etching gas that includes oxygen (O₂).

Using the patterns of the hard mask film 209 and the phase shift film 208 as etching masks, the etch stop film 207 is etched. The etching of the etch stop film 207 is carried out using a chlorine (Cl₂)-based etching gas without oxygen (O₂). Specifically, the end point of the etching of the phase shift film 208 using the chlorine (Cl₂)-based gas with oxygen (O₂) is detected with EPD (End Point Detection) equipment, and then the etching of the etch stop film 207 is performed using a chlorine (Cl₂)-based gas without oxygen (O₂).

If the hard mask film 209 is composed of a TaBO single-layer structure, after etching the etch stop film 207, the hard mask film 209 is removed by etching with the fluorine (F)-based etching gas. In the case of the hard mask film 209 having the TaBO upper layer 209b and the TaBN lower layer 209a, the upper layer 209b is removed by etching with the fluorine (F)-based etching gas, and then the lower layer 209a is removed by etching with the chlorine (Cl₂)-based gas without oxygen (O₂). At this time, the etching process of the etch stop film 207 and the removal process of the lower layer 209a of the hard mask film 209 can be performed simultaneously. For this purpose, the removal process of the upper layer 209b of the hard mask film 209 should be performed before the etching process of the etch stop film 207.

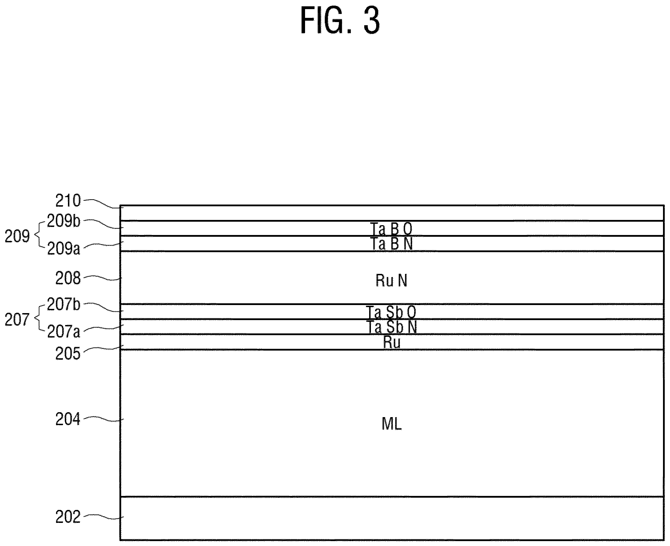

Figure 3 is a diagram illustrating a phase shift blankmask for extreme ultraviolet lithography according to a second embodiment of the present invention. Compared to the first embodiment in Figure 2, the blankmask of the second embodiment in Figure 3 differs only in the etch stop film 207, while the rest of the configuration is the same. For the convenience of reference and explanation in the following embodiments and diagrams, the same reference numerals are used for components corresponding to those described in the previous embodiments.

In the second embodiment, the etch stop film 207 includes a first layer 207a formed on the capping film 205 and a second layer 207b formed on the first layer 207a. The first layer 207a further contains nitrogen (N), and the second layer 207b further contains oxygen (O). Accordingly, the first layer 207a is composed of TaSbN, and the second layer 207b is composed of TaSbO. The first layer 207a contains nitrogen (N) of 1 to 30at%, and the second layer 207b contains oxygen (O) of 1 to 30at%.

The second layer 207b is etched by a fluorine (F)-based etching gas, and the first layer 207a is etched by a chlorine (Cl₂)-based etching gas without oxygen (O₂). Therefore, according to the configuration of the second embodiment, during the etching of the second layer 207b of the etch stop film 207, the upper layer 209b of the hard mask film 209 is simultaneously etched and removed, and during the etching of the first layer 207a of the etch stop film 207, the lower layer 209a of the hard mask film 209 is simultaneously etched and removed. Therefore, a separate process for removing the hard mask film 209 is unnecessary.

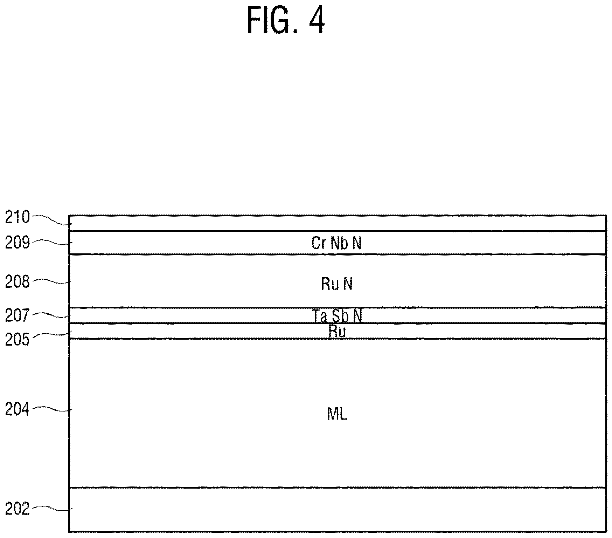

Figure 4 is a diagram illustrating a phase shift blankmask for extreme ultraviolet lithography according to a third embodiment of the present invention. Compared to the first embodiment in Figure 2, the blankmask of the third embodiment in Figure 4 differs only in the hard mask film 209, while the rest of the configuration is the same.

The hard mask film 209 contains chromium (Cr) and niobium (Nb). This hard mask film 209 is etched by a chlorine (Cl₂)-based etching gas, particularly by a chlorine (Cl₂)-based etching gas without oxygen (O₂). It is preferable that the hard mask film 209 is composed of chromium (Cr) and niobium (Nb) in an at% ratio of 3:7 to 6:4. If the content of niobium (Nb) is lower than this ratio, the etching rate by the chlorine (Cl₂)-based gas without oxygen (O₂) is relatively slow, making it difficult to form the resist film 210 to be thin. If the content of niobium (Nb) is higher than this ratio, there is a problem of reduced adhesion with the resist film 210.

The hard mask film 209 may further contain one or more light elements among carbon (C), oxygen (O), and nitrogen (N). In this case, the content of the light element is preferably 1 to 30at%. Specifically, the hard mask film 209 has a composition of Cr of 30-60at%, Nb of 20-40at%, C of 0-10at%, O of 0-30at%, and N of 0-30at%.

In the first and second embodiments described above, the hard mask film 209 has a two-layer structure. Such a two-layer structure helps reduce damage to the phase shift film 208 occurring during the etching of the TaBO single-layer structure of the hard mask film 209 using a fluorine (F)-based etching gas. However, in this two-layer structure, if the lower layer 209a is over-etched, it can lead to poorer pattern profiles for both the upper layer 209b and the lower layer 209a since the lower layer 209a is etched more deeply than the upper layer 208b at the sides thereof. That results in reduced CD (Critical Dimension) reproducibility. However, in this embodiment, the hard mask film 209 is composed of a single layer, so this issue does not arise.

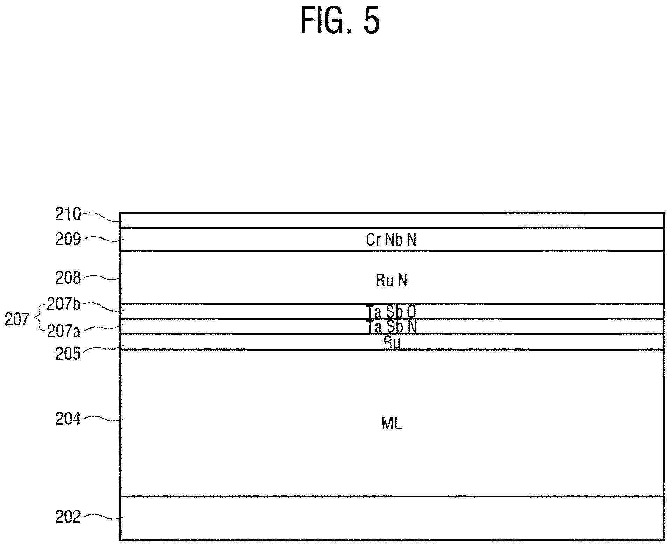

Furthermore, according to this embodiment, a chlorine (Cl₂)-based gas without oxygen (O₂) is used during the etching of the hard mask film 209, so there is no oxygen (O₂)-induced damage to the underlying phase shift film 208. Moreover, as the hard mask film 209 is etched and removed together with the etch stop film 207 using a chlorine (Cl₂)-based gas without oxygen (O₂), the photomask fabrication process becomes simpler. Figure 5 is a diagram illustrating a phase shift blankmask for extreme ultraviolet lithography according to a fourth embodiment of the present invention. Compared to the third embodiment in Figure 4, the blankmask of the fourth embodiment in Figure 5 differs only in the etch stop film 207, while the rest of the configuration is the same. The configuration of the etch stop film 207 in this embodiment is the same as that of the second layer 207b in the second embodiment shown in Figure 3.

In this embodiment, during the etching of the first layer 207a of the etch stop film 207, the hard mask film 209 is simultaneously etched and removed.

Further embodiments of the invention are as follows:
1. A blankmask for extreme ultraviolet lithography, comprising:
   a substrate;
   a reflective film formed on the substrate;
   a capping film formed on the reflective film and containing ruthenium (Ru);
   an etch stop film formed on the capping film and containing tantalum (Ta) and
   antimony (Sb); and
   a phase shift film formed on the etch stop film and containing ruthenium (Ru).
2. The blankmask for extreme ultraviolet lithography according to embodiment 1, wherein the etch stop film has a composition ratio of tantalum (Ta) to antimony (Sb) of 3:7 to 7:3.
3. The blankmask for extreme ultraviolet lithography according to embodiment 1, wherein the etch stop film has a higher amount of content of antimony (Sb) than tantalum (Ta).
4. The blankmask for extreme ultraviolet lithography according to embodiment 3, wherein the etch stop film further includes nitrogen (N).
5. The blankmask for extreme ultraviolet lithography according to embodiment 4, wherein the etch stop film contains nitrogen (N) of 1 to 10at%.
6. The blankmask for extreme ultraviolet lithography according to embodiment 3, wherein the etch stop film comprises a first layer formed on the capping film and containing nitrogen (N), and a second layer formed on the first layer and containing oxygen (O).
7. The blankmask for extreme ultraviolet lithography according to embodiment 6, wherein the first layer contains nitrogen (N) of 1 to 10at%, and the second layer contains oxygen (O) of 1 to 10at%.
8. The blankmask for extreme ultraviolet lithography according to embodiment 3, wherein the etch stop film has a thickness of 2 to 20nm.
9. The blankmask for extreme ultraviolet lithography according to embodiment 1, wherein the phase shift film further includes nitrogen (N).
10. The blankmask for extreme ultraviolet lithography according to embodiment 9, wherein the phase shift film comprises ruthenium (Ru) of 70 to 99at% and nitrogen (N) of 1 to 30at%.
11. The blankmask for extreme ultraviolet lithography according embodiment 1, wherein the phase shift film further includes oxygen (O).
12. The blankmask for extreme ultraviolet lithography according to embodiment 11, wherein the phase shift film comprises ruthenium (Ru) of 70 to 99at% and oxygen (O) of 1 to 30at%.
13. The blankmask for extreme ultraviolet lithography according to embodiment 1, wherein the phase shift film further includes nitrogen (N) and oxygen (O).
14. The blankmask for extreme ultraviolet lithography according to embodiment 13, wherein the phase shift film comprises ruthenium (Ru) of 40 to 98at%, nitrogen (N) of 1 to 30at%, and oxygen (O) of 1 to 30at%.
15. The blankmask for extreme ultraviolet lithography according to embodiment 1, wherein the phase shift film has a thickness of 25 to 40nm.
16. The blankmask for extreme ultraviolet lithography according to embodiment 1, further comprising a hard mask film formed on the phase shift film.
17. The blankmask for extreme ultraviolet lithography according to embodiment 16, wherein the hard mask film comprises tantalum (Ta) and oxygen (O).
18. The blankmask for extreme ultraviolet lithography according to embodiment 17, wherein the hard mask film comprises a lower layer formed on the phase shift film and containing tantalum (Ta) and nitrogen (N), and an upper layer formed on the lower layer and containing tantalum (Ta) and oxygen (O).
19. The blankmask for extreme ultraviolet lithography according to embodiment 18, wherein the lower layer contains tantalum (Ta) of 70 to 99at% and nitrogen (N) of 1 to 30at%, and the upper layer contains tantalum (Ta) of 70 to 99at% and oxygen (O) of 1 to 30at%.
20. The blankmask for extreme ultraviolet lithography according to embodiment 17, wherein the hard mask film further includes boron (B).
21. The blankmask for extreme ultraviolet lithography according to embodiment 16, wherein the hard mask film comprises chromium (Cr) and niobium (Nb).
22. The blankmask for extreme ultraviolet lithography according to embodiment 21, wherein the hard mask film comprises chromium (Cr) and niobium (Nb) in a composition ratio of 3:7 to 6:4.
23. The blankmask for extreme ultraviolet lithography according to embodiment 22, wherein the hard mask film further includes at least one of carbon (C), oxygen (O), and nitrogen (N).
24. The blankmask for extreme ultraviolet lithography according to embodiment 16, wherein the hard mask film has a thickness of 2 to 4nm.
25. A photomask for extreme ultraviolet lithography, produced using the blankmask according to embodiment 1.

Although details of the disclosure have been described above through a few embodiments of the disclosure with reference to the accompanying drawings, the embodiments are merely for the illustrative and descriptive purposes only but not construed as limiting the scope of the disclosure defined in the appended claims. It will be understood by a person having ordinary skill in the art that various changes and other equivalent embodiments may be made from these embodiments. Thus, the scope of the invention should be defined by the technical subject matters of the appended claims.

## Claims

1. A blankmask for extreme ultraviolet lithography, comprising:
a substrate;
a reflective film formed on the substrate;
a capping film formed on the reflective film and containing ruthenium (Ru);
an etch stop film formed on the capping film and containing tantalum (Ta) and
antimony (Sb); and
a phase shift film formed on the etch stop film and containing ruthenium (Ru).

2. The blankmask for extreme ultraviolet lithography according to Claim 1, wherein the etch stop film has a composition ratio of tantalum (Ta) to antimony (Sb) of 3:7 to 7:3.

3. The blankmask for extreme ultraviolet lithography according to Claim 1, wherein the etch stop film has a higher amount of content of antimony (Sb) than tantalum (Ta).

4. The blankmask for extreme ultraviolet lithography according to Claim 3, wherein the etch stop film further includes nitrogen (N) of 1 to 10at%.

5. The blankmask for extreme ultraviolet lithography according to Claim 3, wherein the etch stop film comprises a first layer formed on the capping film and containing nitrogen (N), and a second layer formed on the first layer and containing oxygen (O).

6. The blankmask for extreme ultraviolet lithography according to Claim 5, wherein the first layer contains nitrogen (N) of 1 to 10at%, and the second layer contains oxygen (O) of 1 to 10at%.

7. The blankmask for extreme ultraviolet lithography according to Claim 3, wherein the etch stop film has a thickness of 2 to 20nm.

8. The blankmask for extreme ultraviolet lithography according to any one of Claims 1 to 7, wherein the phase shift film comprises ruthenium (Ru) of 70 to 99at% and one of oxygen (O) and nitrogen (N) of 1 to 30at%.

9. The blankmask for extreme ultraviolet lithography according to any one of Claims 1 to 7, wherein the phase shift film comprises ruthenium (Ru) of 40 to 98at%, nitrogen (N) of 1 to 30at%, and oxygen (O) of 1 to 30at%.

10. The blankmask for extreme ultraviolet lithography according to any one of Claims 1 to 7, further comprising a hard mask film formed on the phase shift film, wherein the hard mask film comprises tantalum (Ta) and oxygen (O).

11. The blankmask for extreme ultraviolet lithography according to Claim 10, wherein the hard mask film comprises a lower layer formed on the phase shift film and containing tantalum (Ta) and nitrogen (N), and an upper layer formed on the lower layer and containing tantalum (Ta) and oxygen (O).

12. The blankmask for extreme ultraviolet lithography according to Claim 11, wherein the lower layer contains tantalum (Ta) of 70 to 99at% and nitrogen (N) of 1 to 30at%, and the upper layer contains tantalum (Ta) of 70 to 99at% and oxygen (O) of 1 to 30at%.

13. The blankmask for extreme ultraviolet lithography according to any one of Claims 1 to 7, further comprising a hard mask film formed on the phase shift film, wherein the hard mask film comprises chromium (Cr) and niobium (Nb).

14. The blankmask for extreme ultraviolet lithography according to Claim 13, wherein the hard mask film comprises chromium (Cr) and niobium (Nb) in a composition ratio of 3:7 to 6:4.

15. A photomask for extreme ultraviolet lithography, produced using the blankmask according to Claim 1.
